# EUROPEAN PATENT APPLICATION

(11) **EP 3 163 619 A1**
(43) Date of publication of application: **03.05.2017**
(21) Application number: 16196131.3
(22) Date of filing: 27.10.2016
(51) Int. Cl.: H01L 27/02, H01L 29/66, H01L 29/78

(54) **SEMICONDUCTOR DEVICE AND RELATED MANUFACTURING METHOD**

(30) Priority: 02.11.2015 CN 201510733008
(71) Applicant: Semiconductor Manufacturing International Corporation (Shanghai), Shanghai 201203 (CN); Semiconductor Manufacturing International Corporation (Beijing), Beijing 1000176 (CN)
(72) Inventor: ZHOU, Fei, Shanghai, 201203 (CN)
(74) Representative: Klunker IP Patentanwälte PartG mbB

(57) **Abstract**

A semiconductor device may include a substrate, a plurality of first-type fin members, and a plurality of second-type fin members. The substrate includes a first-type region and a second-type region. The first-type region and the first-type fin members are n-type if the second-type region and the second-type fin members are p-type. The first-type region and the first-type fin members are p-type if the second-type region and the second-type fin members are n-type. The first-type region directly contacts the second-type region in a cross-sectional view of the semiconductor device. The first-type region directly contacts each of the first-type fin members in the cross-sectional view of the semiconductor device. The second-type region directly contacts each of the second-type fin members in the cross-sectional view of the semiconductor device.

## Description

### CROSS-REFERENCE TO RELATED APPLICATION

This application claims priority to and benefit of Chinese Patent Application No. 201510733008.3, filed on 02 November 2015.

### BACKGROUND

The technical field of the present invention is related to a semiconductor device and a method for manufacturing the semiconductor device.

In semiconductor devices with substantially small sizes, short-channel effects may lead to unsatisfactory performance of the semiconductor devices. A semiconductor device may be implemented with a fin structure for mitigating short-channel effects. Nevertheless, electrostatic discharge in the fin structure may undesirably affect performance of the semiconductor device.

### SUMMARY

A fist aspect of the present invention relates to a semiconductor device. The semiconductor device may include a substrate, a plurality of first-type fin members, and a plurality of second-type fin members. The substrate may include a first-type region and a second-type region. The first-type region and the first-type fin members may be n-type if the second-type region and the second-type fin members are p-type. The first-type region and the first-type fin members may be p-type if the second-type region and the second-type fin members are n-type. The first-type region may directly contact the second-type region in a cross-sectional view of the semiconductor device. The first-type region may directly contact each of the first-type fin members in the cross-sectional view of the semiconductor device. The second-type region may directly contact each of the second-type fin members in the cross-sectional view of the semiconductor device.

A first-type doping concentration value of the first-type fin members may be greater than a first-type doping concentration value of the first-type region. A second-type doping concentration value of the second-type fin members may be greater than a second-type doping concentration value of the second-type region.

The substrate may include a semiconductor portion. A first-type doping concentration of the first-type region may be higher than a first-type doping concentration of the semiconductor portion. The second-type region may be positioned between the plurality of second-type fin members and a first portion of the first-type region in a direction perpendicular to the substrate. The second-type region may be positioned between the semiconductor portion and a second portion of the first-type region in a direction parallel to the substrate. The second-type region may directly contact each of the semiconductor portion, the first portion of the first-type region, and the second portion of the first-type region.

The second-type region may be positioned between the plurality of second-type fin members and a first portion of the first-type region in a direction perpendicular to the substrate. The second-type region may be positioned between a second portion of the first-type region and a third portion of the first-type region in a direction parallel to the substrate. The second-type region may directly contact each of the first portion of the first-type region, the second portion of the first-type region, and the third portion of the first-type region.

The semiconductor device may include a dielectric member. The dielectric member may directly contact each of the first-type region, the second-type region, a first-type fin member among the first-type fin members, and a second-type fin member among the second-type fin members. The dielectric member, the first-type fin member, and the second-type fin member may directly contact a same flat side of the substrate, e.g., a top side of the substrate. The dielectric member may be shorter than each of the first-type fin member and the second-type fin member with reference to the flat side of the substrate.

The first-type fin members may include a first-type fin member. The first-type fin member, i.e. at least one first-type fin member, may include a first first-type fin portion and a second first-type fin portion. The first first-type fin portion may be positioned between the first-type region and the second first-type fin portion. A first-type doping concentration value of the first first-type fin portion may be equal to a first-type doping concentration value of the first-type region and may be less than a first-type doping concentration value of the second first-type fin portion.

The semiconductor device may include a dielectric member. The dielectric member may directly contact each of the first-type region, the second-type region, the first first-type fin portion, the second first-type fin portion, and at least one second-type fin member among the second-type fin members. A top side of the dielectric member may be positioned farther to a top side of the substrate than a top side of the first first-type fin portion. The top side of the dielectric member may be positioned closer to the top side of the substrate than a top side of the second first-type fin portion.

The second-type fin members may include a second-type fin member. The second-type fin member, i.e. at least one second-type fin member, may include a first second-type fin portion and a second second-type fin portion. The first second-type fin portion may be positioned between the second-type region and the second second-type fin portion. A second-type doping concentration value of the first second-type fin portion may be equal to a second-type doping concentration value of the second-type region and may be less than a second-type doping concentration value of the second second-type fin portion.

The semiconductor device may include a dielectric member. The dielectric member may directly contact each of the first-type region, the second-type region, the first second-type fin portion, the second second-type fin portion, and at least one first-type fin member among the first-type fin members. A top side of the dielectric member may be positioned farther to a top side of the substrate than a top side of the first second-type fin portion. The top side of the dielectric member may be positioned closer to the top side of the substrate than a top side of the second second-type fin portion.

A second aspect of the present invention relates to a method for manufacturing a semiconductor device. The method may include the following steps: preparing a structure that includes a substrate, a first plurality of fin members, and a second plurality of fin members; forming a first-type region and a second-type region in the substrate; processing the second plurality of fin members to form a plurality of second-type fin members; and processing the first plurality of fin members to form a plurality of first-type fin members. The first-type region and the first-type fin members may be n-type if the second-type region and the second-type fin members are p-type. The first-type region and the first-type fin members may be p-type if the second-type region and the second-type fin members are n-type. The first-type region may directly contact the second-type region in a cross-sectional view of the semiconductor device. The first-type region may directly contact each of the first-type fin members in the cross-sectional view of the semiconductor device. The second-type region may directly contact each of the second-type fin members in the cross-sectional view of the semiconductor device.

A first-type doping concentration value of the first-type fin members may be greater than a first-type doping concentration value of the first-type region. A second-type doping concentration value of the second-type fin members may be greater than a second-type doping concentration value of the second-type region.

The substrate may include a semiconductor portion. A first-type doping concentration of the first-type region may be higher than a first-type doping concentration of the semiconductor portion. The second-type region may be positioned between the plurality of second-type fin members and a first portion of the first-type region in a direction perpendicular to the substrate. The second-type region may be positioned between the semiconductor portion and a second portion of the first-type region in a direction parallel to the substrate. The second-type region may directly contact each of the semiconductor portion, the first portion of the first-type region, and the second portion of the first-type region.

The second-type region may be positioned between the plurality of second-type fin members and a first portion of the first-type region in a direction perpendicular to the substrate. The second-type region may be positioned between a second portion of the first-type region and a third portion of the first-type region in a direction parallel to the substrate. The second-type region may directly contact each of the first portion of the first-type region, the second portion of the first-type region, and the third portion of the first-type region.

The method may include providing a dielectric member. Each of the first-type region, the second-type region, at least one first-type fin member among the first-type fin members, and at least one second-type fin member among the second-type fin members may directly contact the dielectric member. The dielectric member, the at least one first-type fin member, and the at least one second-type fin member directly contact a same flat side of the substrate. The dielectric member may be shorter than each of the first-type fin member and the second-type fin member with reference to the flat side of the substrate.

The first-type fin members may include a first-type fin member. The first-type fin member, i.e. at least one first-type fin member, may include a first first-type fin portion and a second first-type fin portion. The first first-type fin portion may be positioned between the first-type region and the second first-type fin portion. A first-type doping concentration value of the first first-type fin portion may be equal to a first-type doping concentration value of the first-type region and may be less than a first-type doping concentration value of the second first-type fin portion.

The method may include: providing a dielectric member. Each of the first-type region, the second-type region, the first first-type fin portion, the second first-type fin portion, and at least one second-type fin member among the second-type fin members may directly contact the dielectric member. A top side of the dielectric member may be positioned farther to a top side of the substrate than a top side of the first first-type fin portion. The top side of the dielectric member may be positioned closer to the top side of the substrate than a top side of the second first-type fin portion.

The second-type fin member may include a first second-type fin portion and a second second-type fin portion. The first second-type fin portion may be positioned between the second-type region and the second second-type fin portion. A second-type doping concentration value of the first second-type fin portion may be equal to a second-type doping concentration value of the second-type region and may be less than a second-type doping concentration value of the second second-type fin portion. Each of the first second-type fin portion and the second second-type fin portion may directly contact the dielectric member.

According to embodiments, in a semiconductor device, a p-n junction may extend parallel to fin members, such that an area and/or a perimeter of the p-n junction may be maximized. Therefore, an electrical resistance at the p-n junction may be minimized, such that negative effects of potential electrostatic charge may be mitigated or substantially prevented. Advantageously, satisfactory performance of the semiconductor device may be attained.

The above summary of the present invention is related only to some of many embodiments disclosed herein and is not intended to limit the scope of the invention which is defined in the claims.

### BRIEF DESCRIPTION OF THE DRAWINGS

FIG. 1 shows a flowchart that illustrates steps in a method for manufacturing one or more semiconductor devices in accordance with one or more embodiments.
FIG. 2A, FIG. 2B, FIG. 3A, FIG. 3B, FIG. 4A, FIG. 4B, FIG. 4C, FIG. 4D, FIG. 5A, FIG. 5B, FIG. 5C, FIG. 5D, FIG. 6A, FIG. 6B, FIG. 6C, FIG. 6D, FIG. 7A, FIG. 7B, and FIG. 7C show schematic diagrams (e.g., schematic cross-sectional views) that illustrate elements and/or structures formed in a method for manufacturing one or more semiconductor devices in accordance with one or more embodiments.
FIG. 8A and FIG. 8B show schematic diagrams (e.g., schematic cross-sectional views) that illustrate elements and/or structures in one or more semiconductor devices in accordance with one or more embodiments.

### DETAILED DESCRIPTION

Example embodiments are described with reference to the accompanying drawings. Well known process steps and/or structures may not have been described in detail in order to not unnecessarily obscure described embodiments.

The drawings and description are illustrative and not restrictive. Like reference numerals may designate like (e.g., analogous or identical) elements in the specification. Repetition of description may be avoided.

The relative sizes and thicknesses of elements shown in the drawings are for facilitate description and understanding, without limiting possible embodiments. In the drawings, the thicknesses of some layers, films, panels, regions, etc., may be exaggerated for clarity.

Illustrations of example embodiments in the figures may represent idealized illustrations. Variations from the shapes illustrated in the illustrations, as a result of, for example, manufacturing techniques and/or tolerances, may be possible. Thus, the example embodiments should not be construed as limited to the shapes or regions illustrated herein but are to include deviations in the shapes. For example, an etched region illustrated as a rectangle may have rounded or curved features. The shapes and regions illustrated in the figures are illustrative and should not limit the scope of the example embodiments.

Although the terms "first", "second", etc. may be used herein to describe various elements, these elements should not be limited by these terms. These terms may be used to distinguish one element from another element. Thus, a first element discussed in this application may be termed a second element without departing from embodiments. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

If a first element (such as a layer, film, region, or substrate) is referred to as being "on", "neighboring", "connected to", or "coupled with" a second element, then the first element can be directly on, directly neighboring, directly connected to, or directly coupled with the second element, or an intervening element may also be present between the first element and the second element. If a first element is referred to as being "directly on", "directly neighboring", "directly connected to", or "directed coupled with" a second element, then no intended intervening element (except environmental elements such as air) may be provided between the first element and the second element.

Spatially relative terms, such as "beneath", "below", "lower", "above", "upper", and the like, may be used herein for ease of description to describe one element or feature's spatial relationship to another element(s) or feature(s) as illustrated in the figures. It will be understood that the spatially relative terms may encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein should be interpreted accordingly.

The terminology used herein is for the purpose of describing particular embodiments and is not intended to limit the embodiments. As used herein, the singular forms, "a", "an", and "the" may indicate plural forms as well, unless the context clearly indicates otherwise. The terms "includes" and/or "including", when used in this specification, may specify the presence of stated features, integers, steps, operations, elements, and/or components, but may not preclude the presence or addition of one or more other features, integers, steps, operations, elements, components, and/or groups.

Unless otherwise defined, terms (including technical and scientific terms) used herein have the same meanings as commonly understood by one of ordinary skill in the art. Terms, such as those defined in commonly used dictionaries, should be interpreted as having meanings that are consistent with their meanings in the context of the relevant art and should not be interpreted in an idealized or overly formal sense unless expressly so defined herein.

The term "connect" may mean "electrically connect". The term "insulate" may mean "electrically insulate". The term "conductive" may mean "electrically conductive". The term "electrically connected" may mean "electrically connected without any intervening transistors".

The term "conductor" may mean "electrically conductive member". The term "insulator" may mean "electrically insulating member". The term "dielectric" may mean "dielectric member". The term "interconnect" may mean "interconnecting member". The term "provide" may mean "provide and/or form". The term "form" may mean "provide and/or form".

Unless explicitly described to the contrary, the word "comprise" and variations such as "comprises", "comprising", "include", or "including" may imply the inclusion of stated elements but not the exclusion of other elements.

Various embodiments, including methods and techniques, are described in this disclosure. Embodiments may also cover an article of manufacture that includes a non-transitory computer readable medium on which computer-readable instructions for carrying out embodiments of the inventive technique are stored. The computer readable medium may include, for example, semiconductor, magnetic, opto-magnetic, optical, or other forms of computer readable medium for storing computer readable code. Further, embodiments may also cover apparatuses for practicing embodiments. Such apparatus may include circuits, dedicated and/or programmable, to carry out operations pertaining to embodiments. Examples of such apparatus include a general purpose computer and/or a dedicated computing device when appropriately programmed and may include a combination of a computer/computing device and dedicated/programmable hardware circuits (such as electrical, mechanical, and/or optical circuits) adapted for the various operations pertaining to embodiments.

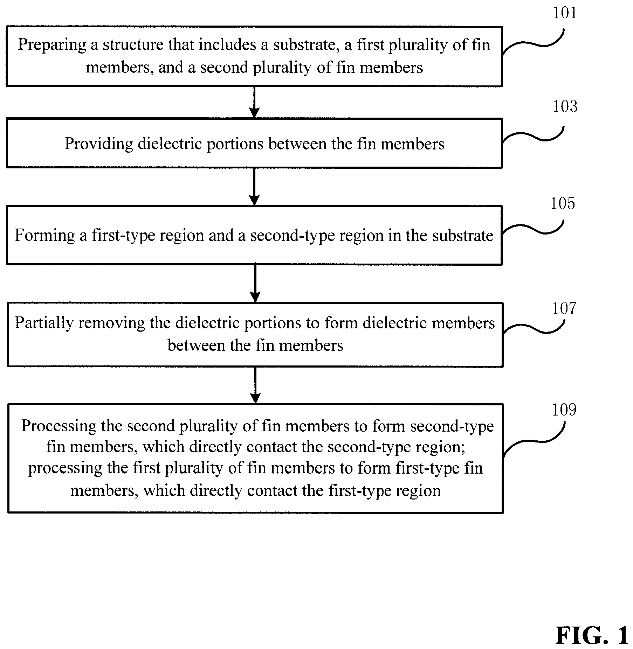

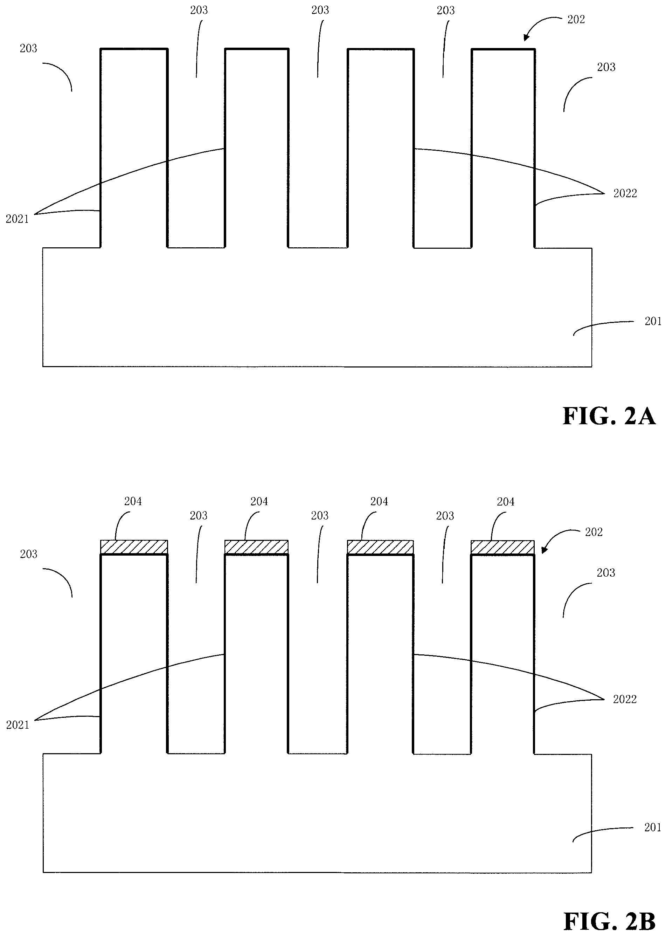

FIG. 1 shows a flowchart that illustrates steps in a method for manufacturing one or more semiconductor devices in accordance with one or more embodiments. The method may include steps 101, 103, 105, 107, 109, and 111. FIG. 2A, FIG. 2B, FIG. 3A, FIG. 3B, FIG. 4A, FIG. 4B, FIG. 4C, FIG. 4D, FIG. 5A, FIG. 5B, FIG. 5C, FIG. 5D, FIG. 6A, FIG. 6B, FIG. 6C, FIG. 6D, FIG. 7A, FIG. 7B, and FIG. 7C show schematic diagrams (e.g., schematic cross-sectional views) that illustrate elements and/or structures formed in the method in accordance with one or more embodiments.

Referring to FIG. 1 and FIG. 2A, the step 101 may include preparing a structure that includes a substrate 201 and a plurality of fin members 202 positioned on the substrate 201. The plurality of fin members 202 may include a plurality of fin members 2021 and a plurality of fin members 2022 to be processed differently in subsequent steps. Trenches 203 (or spaces 203) may exist between the fin members 202. Referring to FIG. 2A, mask portions 204 may be positioned on the fin members 202.

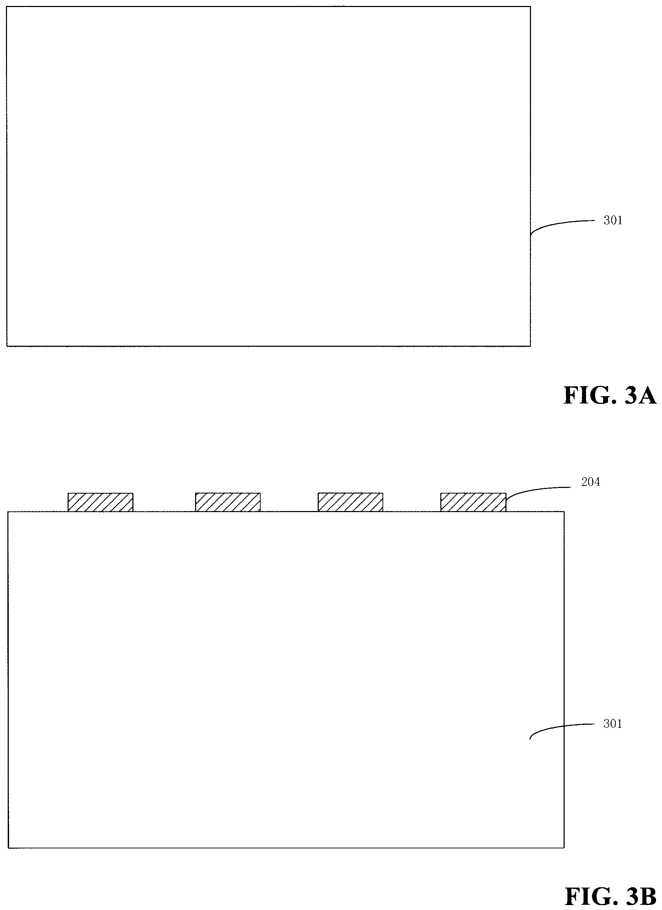

Referring to FIG. 3A and FIG. 3B, the step 101 may include the following steps: preparing a semiconductor member 301; providing mask portions 204 on the semiconductor member 301; and partially removing (e.g., through dry etching and/or wet etching) the semiconductor member 301 through spaces between the mask portions 204 to form the structure that includes the fin members 202 on the substrate 201. The mask portions 204 may be removed after the fin members 202 have been formed.

The semiconductor member 301 may be or may include an elemental semiconductor member (e.g., a silicon member and/or a germanium member) and/or a compound semiconductor member (e.g., a gallium arsenide member). The mask portions 204 may include or may be formed of at least one of silicon nitride, silicon oxide, silicon oxynitride, etc. In an embodiment, buffer portions may be provided between the semiconductor member 301 and the mask portions 204 for securing the mask portions 204 on the semiconductor member 301.

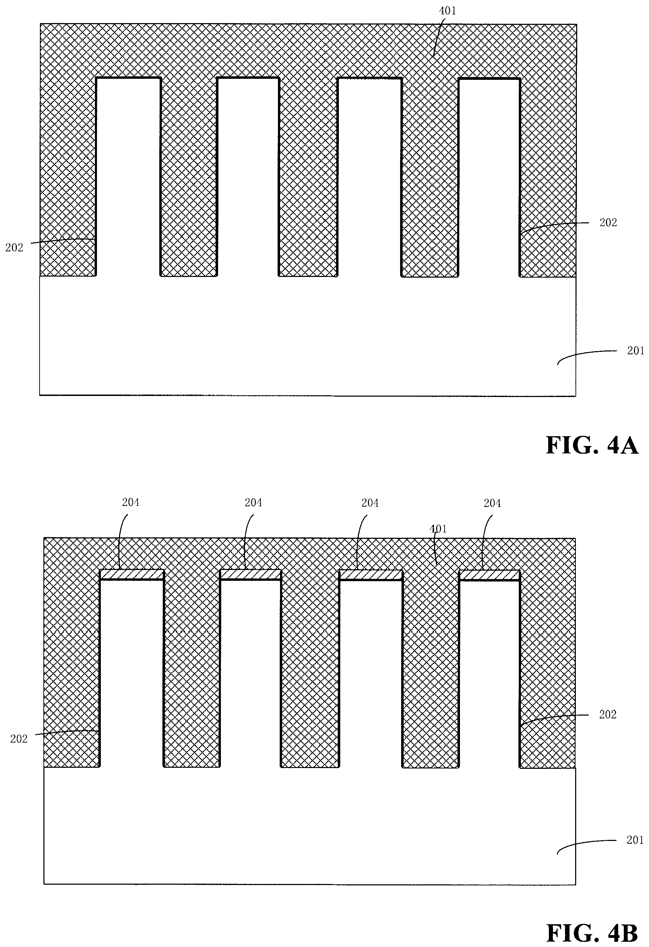

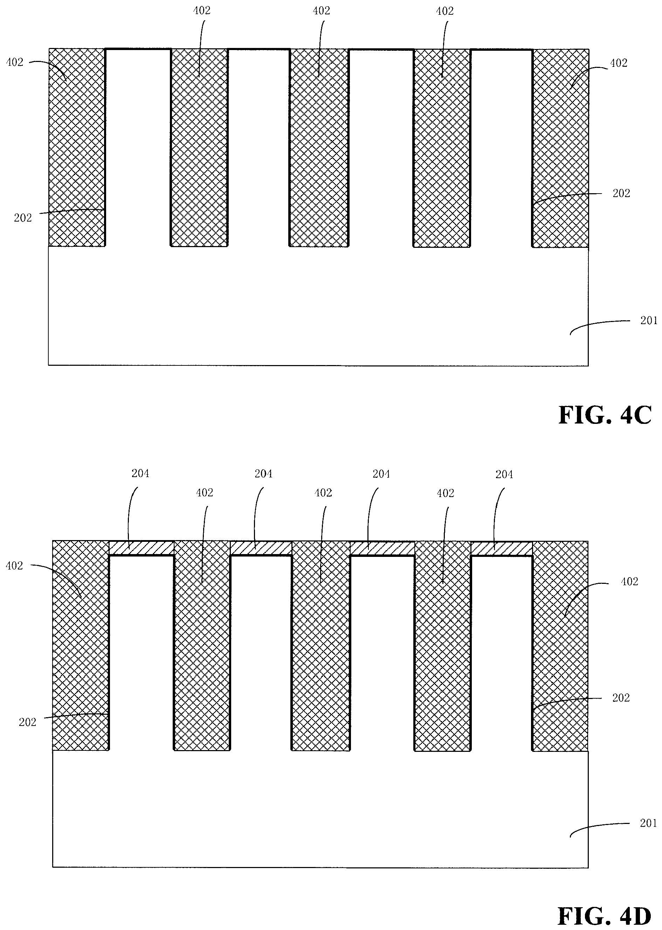

Referring to FIG. 1, FIG. 4A, FIG. 4B, FIG. 4C, and FIG. 4D, the step 103 may include providing dielectric portions 402 between the fin members 202. The step 103 may include the following steps: providing a dielectric material layer 401 that extends into (and fills) the trenches 203 between the fin members 202; and planarize the dielectric material layer 401 (down to the top sides of the fin members 202 or the top sides of the mask portions 204) to form the dielectric portions 402 between the fin members 202 for isolating (and/or insulating) the fin members 202.

The dielectric material layer 401 may be provided through a chemical vapor deposition (CVD) process, e.g., a flowable chemical vapor deposition (FCVD) process. In an embodiment, before the dielectric material layer 401 is provided, a repair layer (e.g., a thin silicon oxide layer formed by thermal oxidation) may be formed on surfaces of the substrate 201 and surfaces of the fin member 202 for repairing damages of the substrate 201 and the fin members 202 that have incurred during formation of the fin members 202 (e.g., during the etching process in the step 101). Portions of the repair layer may be subsequently removed in the step 107.

The dielectric material layer 401 may be planarized through a chemical-mechanical planarization process. In an embodiment, the mask portions 204 may be removed in the planarization process.

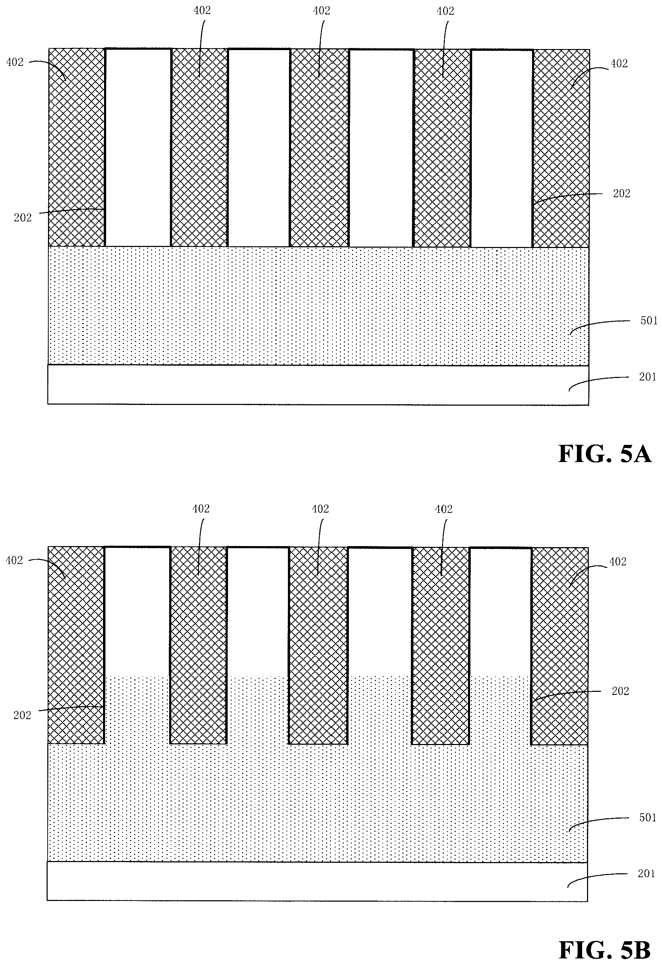

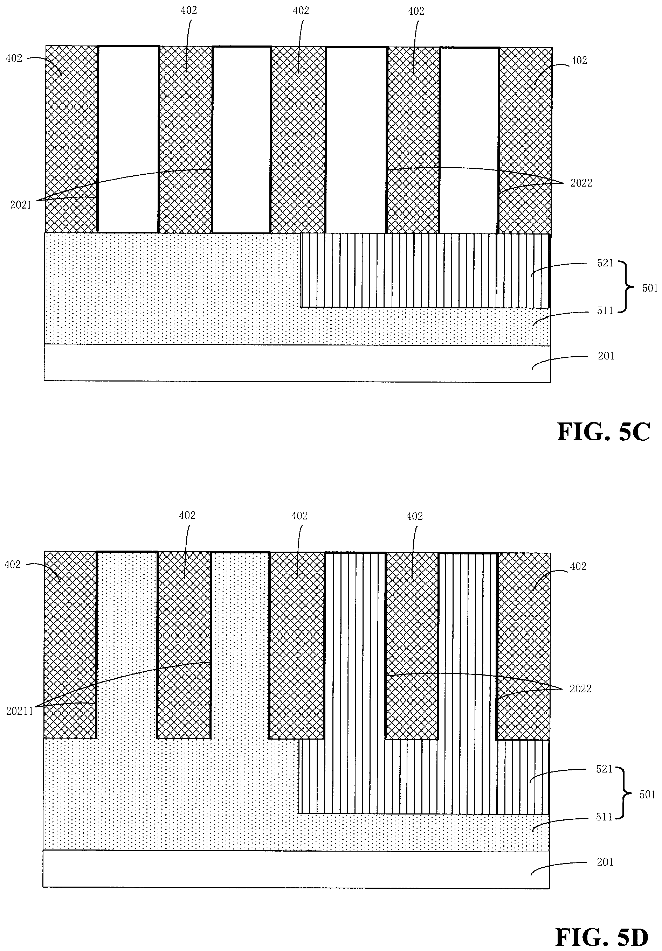

Referring to FIG. 1, FIG. 5A, FIG. 5B, FIG. 5C, and FIG. 5D, the step 105 may include forming a first-type region 511 and a second-type region 521 in the substrate 201. The first-type region 511 may be n-type if the second-type region 521 is p-type. The first-type region 511 may be p-type if the second-type region 521 is n-type.

Referring to FIG. 5A, the step 105 may include performing a first doping process (e.g., a first ion implantation process) on the substrate 201 to form a first-type well 501. Suitable first-type dopants may be selected for performing the first doping process to form the first-type well 501 to be an n-well (i.e., an n-type well) or a p-well (i.e., a p-type well). For forming the n-well, phosphorus ions may be implanted into the substrate 201 using an implantation energy in a range of 120 KeV to 180 KeV and using an implantation dose in a range of 5.0 x 10^2 atom/cm^2 to 5.0 x 10^3 atom/cm^2. Forming the p-well, boron ions may be implanted into the substrate using an implantation energy in a range of 40 KeV to 80 KeV and using an implantation dose in a range of 5.0 x 10^12 atom/cm^2 to 1.0 x 10^14 atom/cm^2. After the first doping process, an annealing process, e.g., a rapid thermal annealing (RTA) process may be performed to promote and/or optimize distribution of first-type dopants. The annealing process may be performed at a temperature in a range of 950 degrees Celsius to 1050 degrees Celsius for a time period in a range of 5 seconds to 20 seconds.

Referring to FIG. 5B, as a result of the first doping process (and the associated annealing process), some first-type dopants may be implanted into and/or may diffuse into portions of the fin members 202.

Referring to FIG. 5C, the step 105 may include using second-type dopants to perform a second doping process (e.g., a second ion implantation process) on a portion of the first-type well 501 that directly contacts the fin members 2022, such that the portion doped with second-type dopants may become the second-type region 521. The remaining portion of the first-type well 501, which directly contacts the fin members 2021 and is not substantially doped with second-type dopants, may become the first-type region 511. After the first doping process, an annealing process, e.g., a rapid thermal annealing (RTA) process may be performed to promote and/or optimize distribution of second-type dopants. As a result of the second doping process (and the associated annealing process), some second-type dopants may be implanted into and/or may diffuse into portions of the fin members 2022.

Referring to FIG. 5D, as a result of the first doping process (and the subsequent annealing process), some first-type dopants may be implanted into and/or may diffuse into substantial portions of the fin members 2021 or the whole fin members 2021. As a result of the second doping process (and the associated annealing process), some second-type dopants may be implanted into and/or may diffuse into substantial portions of the fin members 2022 or the whole fin members 2022.

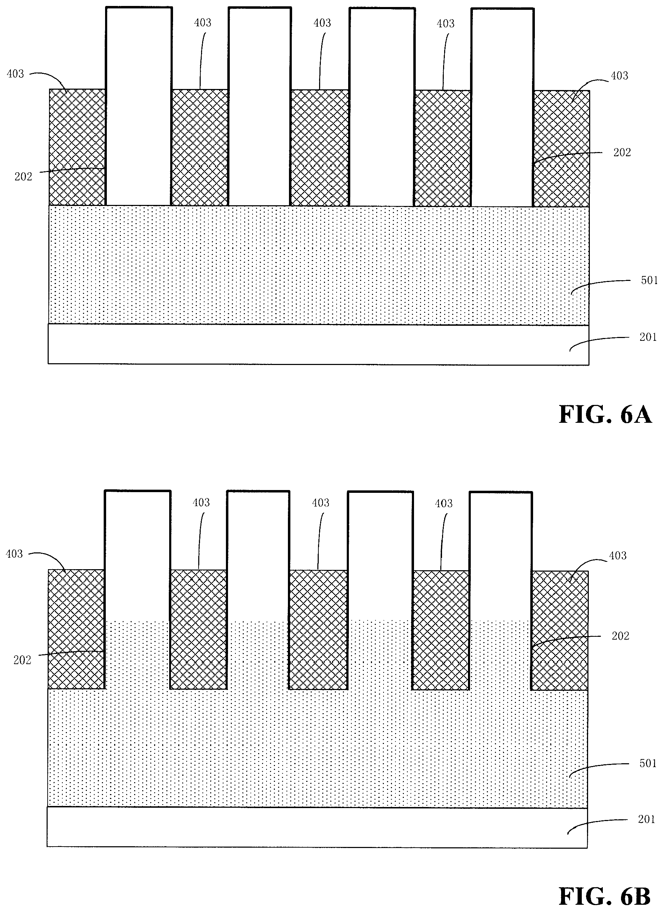

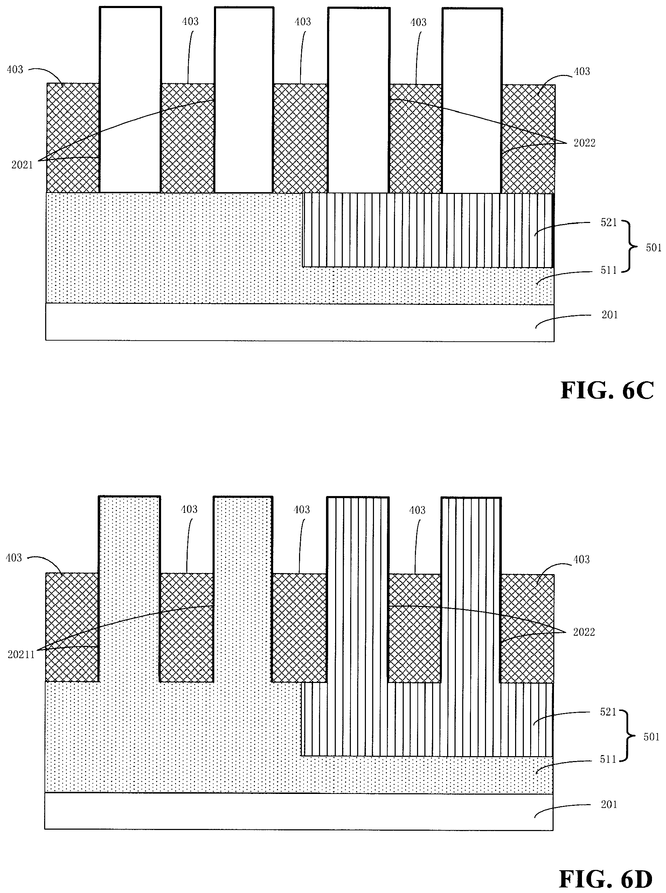

Referring to FIG. 1, FIG. 6A, FIG. 6B, FIG. 6C, and FIG. 6D, the step 107 may include partially removing (e.g., through an etch-back process) the dielectric portions 402 to form dielectric members 403 between the fin members 202 (including fin members 2021 and 2022). As a result, upper portions of the fin members 202 may be exposed.

The dielectric portions 402 may be partially removed for forming the dielectric members 403 before or after formation of one or more of the first-type region 511 and the second-type region 521. If a repair layer has been formed on the fin members 202, portions of the repair layer may also be removed along with removed portions of the dielectric portions 402.

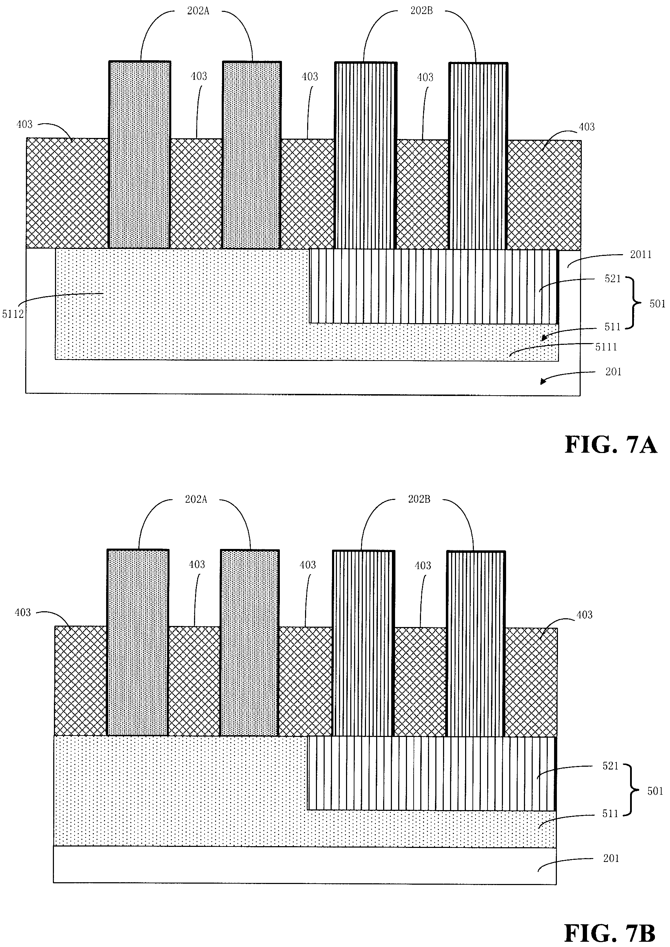

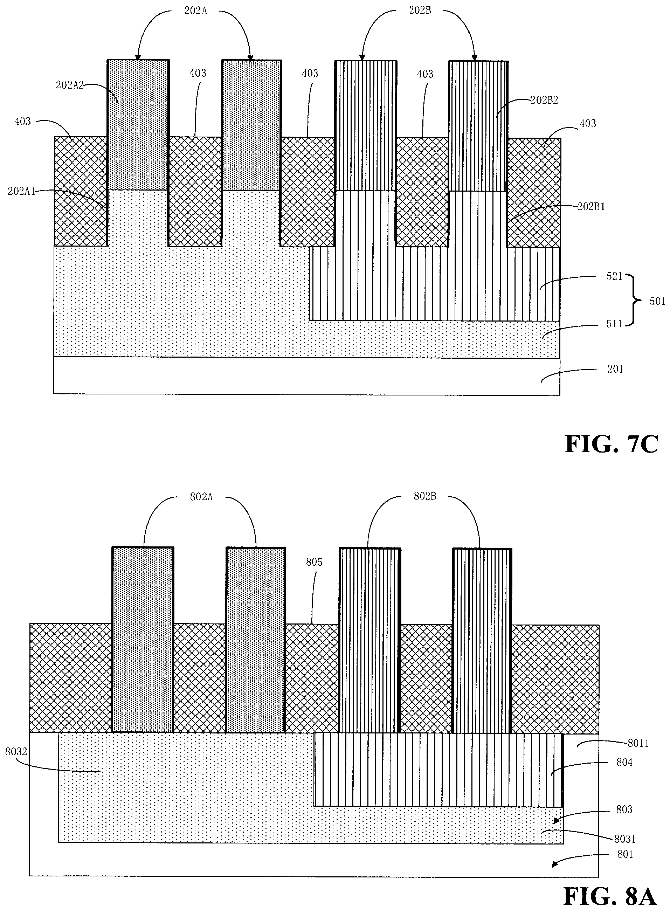

Referring to FIG. 1, FIG. 7A, FIG. 7B, and FIG. 7C, the step 109 may include the following steps: processing the fin members 2022 to form a plurality of second-type fin members 202B, which may directly contact the second-type region 521; and subsequently processing the fin members 2021 to form a plurality of first-type fin members 202A, which may directly contact the first-type region 511. The second-type fin members 202B may be formed before the first-type fin members 202A. In an embodiment, the first-type fin members 202A may be formed before the second-type fin members 202B.

Second-type dopants may be used for performing a third doping process (e.g., a third ion implantation process) on the fin members 2022 to form the second-type fin members 202B. A second-type doping concentration value of the second-type fin members 202B may be higher than a second-type doping concentration value of the second-type region 521.

First-type dopants may be used for performing a fourth doping process (e.g., a fourth ion implantation process) on the fin members 2021 to form the first-type fin members 202A. A first-type doping concentration value of the first-type fin members 202A may be higher than a first-type doping concentration value of the first-type region 511.

Before formation of the first-type fin members 2021 and the second-type fin members 2022, the mask portions 204 may be removed or retained, and/or thermal oxide layers may be formed on exposed portions of the fin members 2021 and 2022.

Referring to FIG. 7A, the substrate 201 may include a semiconductor portion 2011. A first-type doping concentration of the first-type region 511 may be higher than a first-type doping concentration of the semiconductor portion 2011. The second-type region 521 may be positioned between the plurality of second-type fin members 202B and a portion 5111 of the first-type region 511 in a direction perpendicular to the substrate 201. The second-type region 521 may be positioned between the semiconductor portion 2011 and a portion 5112 of the first-type region 511 in a direction parallel to the substrate 201. Two sides of the second-type region 521 may respectively directly contact the semiconductor portion 2011 and the portion 5112 of the first-type region 511 and may be substantially parallel to each other. A third side of the second-type region 521 may directly contact the portion 5111 of the first-type region 511 and may be parallel to the substrate 201.

Referring to FIG. 7A and FIG. 7B, the dielectric members 403 may include a dielectric member 403 positioned between the first-type fin members 202A and the second-type fin members 202B. Each of the first-type region 511, the second-type region 521, a first-type fin member 202A among the first-type fin members 202A, and a second-type fin member 202B among the second-type fin members 202B may directly contact the dielectric members 403. The dielectric members 403, the first-type fin member 202A, and the second-type fin member 202B directly contact a same flat side (e.g., the top side) of the substrate 201. The dielectric member 403 may be shorter than each of the first-type fin member 202A and the second-type fin member 202B with reference to the flat side of the substrate 201.

Referring to FIG. 7C, the first-type fin members 202A may include a first-type fin member 202A. The first-type fin member 202A may include a first-type fin portion 202A1 (e.g., a lower portion) and a first-type fin portion 202A2 (e.g., an upper portion). The first-type fin portion 202A1 may be positioned between the first-type region 511 and the first-type fin portion 202A2. A first-type doping concentration value of the first-type fin portion 202A1 may be equal to a first-type doping concentration value of the first-type region 511 and may be less than a first-type doping concentration value of the first-type fin portion 202A2.

Referring to FIG. 7C, the dielectric members 403 may include a dielectric member 403 positioned between the first-type fin members 202A and the second-type fin members 202B. Each of the first-type region 511, the second-type region 521, the first-type fin portion 202A 1, the first-type fin portion 202A2, and a second-type fin member 202B among the second-type fin members 202B may directly contact the dielectric members 403. A top side of the dielectric members 403 may be positioned farther to a top side of the substrate 201 than a top side of the first-type fin portion 202A1 (and/or may be higher than the top side of the first-type fin portion 202A1). The top side of the dielectric members 403 may be positioned closer to the top side of the substrate 201 than a top side of the first-type fin portion 202A2 (and/or may be lower than the top side of the first-type fin portion 202A2).

Referring to FIG. 7C, a second-type fin member 202B may include a second-type fin portion 202B1 and a second-type fin portion 202B2. The second-type fin portion 202B1 may be positioned between the second-type region 521 and the second-type fin portion 202B2. A second-type doping concentration value of the second-type fin portion 202B1 may be equal to a second-type doping concentration value of the second-type region 521 and may be less than a second-type doping concentration value of the second-type fin portion 202B2. Each of the second-type fin portion 202B1 and the second-type fin portion 202B2 may directly contact the dielectric members 403.

Referring to FIG. 7A, FIG. 7B, and FIG. 7C, the first-type region 511 may directly contact the second-type region 521 in a cross-sectional view of the semiconductor device. The first-type region 511 may directly contact all of the first-type fin members 202A in the same cross-sectional view of the semiconductor device, i.e., the first-type region 511 may directly contact a plurality of first-type fin members 202A in the same cross-sectional view of the semiconductor device. The second-type region 521 may directly contact all of the second-type fin members 202B in the same cross-sectional view of the semiconductor device, i.e., the second-type region 521 may directly contact a plurality of second-type fin members 202B in the same cross-sectional view of the semiconductor device. In the semiconductor device, a p-n junction between the first-type region 511 and the second-type region 521 may extend parallel to the fin members 202A and 202B, such that an area and/or a perimeter of the p-n junction may be maximized. Therefore, an electrical resistance at the p-n junction may be minimized, such that negative effects of potential electrostatic charge may be mitigated or substantially prevented. Advantageously, satisfactory performance of the semiconductor device may be attained.

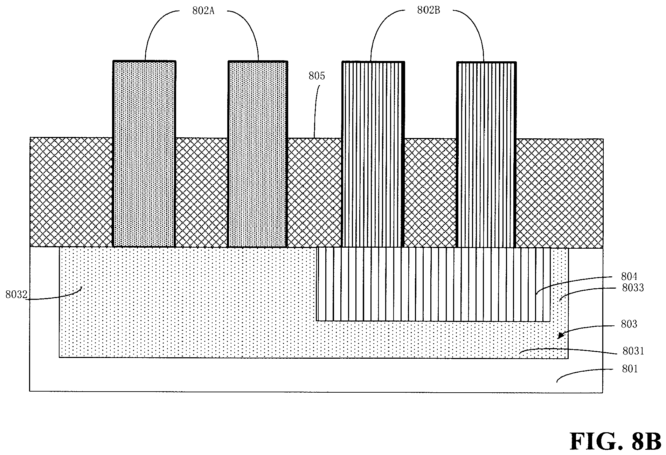

FIG. 8A and FIG. 8B show schematic diagrams (e.g., schematic cross-sectional views) that illustrate elements and/or structures in one or more semiconductor devices in accordance with one or more embodiments.

Referring to FIG. 8A and FIG. 8B, the semiconductor device may include a substrate 801, a plurality of first-type fin members 802A, and a plurality of second-type fin members 802B. The substrate 801 may include a first-type region 803 and a second-type region 804. The first-type region 803 and the first-type fin members 802A may be n-type if the second-type region 804 and the second-type fin members 802B are p-type. The first-type region 803 and the first-type fin members 802A may be p-type if the second-type region 804 and the second-type fin members 802B are n-type.

The first-type region 803 may directly contact the second-type region 804 in a cross-sectional view of the semiconductor device. The first-type region 803 may directly contact each of the first-type fin members 802A in the same cross-sectional view of the semiconductor device. The second-type region 804 may directly contact each of the second-type fin members 802B in the same cross-sectional view of the semiconductor device. A p-n junction between the first-type region 803 and the second-type region 804 may extend parallel to the fin members 802A and 802B, such that an area and/or a perimeter of the p-n junction may be maximized. Therefore, an electrical resistance at the p-n junction may be minimized, such that negative effects of potential electrostatic charge may be mitigated or substantially prevented. Advantageously, satisfactory performance of the semiconductor device may be attained.

A first-type doping concentration value of the first-type fin members 802A may be greater than a first-type doping concentration value of the first-type region 803. A second-type doping concentration value of the second-type fin members 802B may be greater than a second-type doping concentration value of the second-type region 804.

Referring to FIG. 8A, the substrate 801 may include a semiconductor portion 8011. A first-type doping concentration of the first-type region 803 may be higher than a first-type doping concentration of the semiconductor portion 8011. The second-type region 804 may be positioned between the plurality of second-type fin members 802B and a portion 8031 of the first-type region 803 in a direction perpendicular to the substrate 801. The second-type region 804 may be positioned between the semiconductor portion 8011 and a portion 8032 of the first-type region 803 in a direction parallel to the substrate 801. The second-type region 804 may directly contact each of the semiconductor portion 8011, the portion 8031 of the first-type region 803, and the portion 8032 of the first-type region 803.

Referring to FIG. 8B, the second-type region 804 may be positioned between the plurality of second-type fin members 802B and a portion 8031 of the first-type region 803 in a direction perpendicular to the substrate 801. The second-type region 804 may be positioned between a portion 8032 of the first-type region 803 and a portion 8033 of the first-type region 803 in a direction parallel to the substrate 801. The second-type region 804 may directly contact each of the portion 8031 of the first-type region 803, the portion 8032 of the first-type region 803, and the portion 8033 of the first-type region 803. Two sides of the second-type region 804 may respectively directly contact the portion 8032 of the first-type region 803 and the portion 8033 of the first-type region 803 and may be substantially parallel to each other.

Referring to FIG. 8A and FIG. 8B, the semiconductor device may include a dielectric member 805. The dielectric member 805 may directly contact each of the first-type region 803, the second-type region 804, a first-type fin member 802A among the first-type fin members 802A, and a second-type fin member 802B among the second-type fin members 802B. The dielectric member 805, the first-type fin members 802A, and the second-type fin members 802B may directly contact a same flat side of the substrate 801, e.g., a top side of the substrate 801. The dielectric member 805 may be shorter than each of the first-type fin members 802A and the second-type fin members 802B with reference to the flat side of the substrate 801.

According to embodiments, in a semiconductor device, a p-n junction may extend parallel to fin members, such that an area and/or a perimeter of the p-n junction may be maximized. Therefore, an electrical resistance at the p-n junction may be minimized, such that negative effects of potential electrostatic charge may be mitigated or substantially prevented.

## Claims

1. A semiconductor device, comprising:
a substrate;
a plurality of first-type fin members with a first-type doping concentration value; and
a plurality of second-type fin members with a second-type doping concentration value,
wherein the substrate comprises a first-type region with a first-type doping concentration value and a second-type region with a second-type doping concentration value,
wherein the first-type region and the first-type fin members are n-type if the second-type region and the second-type fin members are p-type, or the first-type region and the first-type fin members are p-type if the second-type region and the second-type fin members are n-type,
wherein the first-type region directly contacts the second-type region in a cross-sectional view of the semiconductor device,
wherein the first-type region directly contacts each of the first-type fin members in the cross-sectional view of the semiconductor device, and
wherein the second-type region directly contacts each of the second-type fin members in the cross-sectional view of the semiconductor device.

2. The semiconductor device according to claim 1,
wherein the first-type doping concentration value of the first-type fin members is greater than the first-type doping concentration value of the first-type region, and
wherein the second-type doping concentration value of the second-type fin members is greater than the second-type doping concentration value of the second-type region.

3. The semiconductor device according to claim 1 or 2,
wherein the substrate comprises a semiconductor portion,
wherein the first-type doping concentration value of the first-type region is higher than a first-type doping concentration value of the semiconductor portion,
wherein the second-type region is positioned between the plurality of second-type fin members and a first portion of the first-type region in a direction perpendicular to the substrate,
wherein the second-type region is positioned between the semiconductor portion and a second portion of the first-type region in a direction parallel to the substrate, and
wherein the second-type region directly contacts each of the semiconductor portion, the first portion of the first-type region, and the second portion of the first-type region.

4. The semiconductor device according to any one of the claims 1-3,
wherein the second-type region is positioned between the plurality of second-type fin members and a first portion of the first-type region in a direction perpendicular to the substrate,
wherein the second-type region is positioned between a second portion of the first-type region and a third portion of the first-type region in a direction parallel to the substrate, and
wherein the second-type region directly contacts each of the first portion of the first-type region, the second portion of the first-type region, and the third portion of the first-type region.

5. The semiconductor device of any one of the claims 1-4 comprising: a dielectric member, which directly contacts each of the first-type region, the second-type region, a first-type fin member among the first-type fin members, and a second-type fin member among the second-type fin members, and
wherein preferably the dielectric member, the first-type fin member, and the second-type fin member directly contact a same flat side of the substrate, and the dielectric member is shorter than each of the first-type fin member and the second-type fin member with reference to the flat side of the substrate.

6. The semiconductor device according to any one of the claims 1-4,
wherein at least one first-type fin member comprises a first first-type fin portion and a second first-type fin portion,
wherein the first first-type fin portion is positioned between the first-type region and the second first-type fin portion, and
wherein a first-type doping concentration value of the first first-type fin portion is equal to the first-type doping concentration value of the first-type region and is less than a first-type doping concentration value of the second first-type fin portion.

7. The semiconductor device according to claim 6 comprising: a dielectric member, which directly contacts each of the first-type region, the second-type region, the first first-type fin portion, the second first-type fin portion, and at least one second-type fin member among the second-type fin members, and
wherein preferably a top side of the dielectric member is positioned farther to a top side of the substrate than a top side of the first first-type fin portion, and the top side of the dielectric member is positioned closer to the top side of the substrate than a top side of the second first-type fin portion.

8. The semiconductor device according to any one of the of claim 1-4, 6, and 7,
wherein at least one second-type fin member comprises a first second-type fin portion and a second second-type fin portion,
wherein the first second-type fin portion is positioned between the second-type region and the second second-type fin portion, and
wherein a second-type doping concentration value of the first second-type fin portion is equal to the second-type doping concentration value of the second-type region and is less than a second-type doping concentration value of the second second-type fin portion.

9. The semiconductor device according to claim 8 comprising: a dielectric member, which directly contacts each of the first-type region, the second-type region, the first second-type fin portion, the second second-type fin portion, and at least one first-type fin member among the first-type fin members, and
wherein preferably a top side of the dielectric member is positioned farther to a top side of the substrate than a top side of the first second-type fin portion, and the top side of the dielectric member is positioned closer to the top side of the substrate than a top side of the second second-type fin portion.

10. A method for manufacturing a semiconductor device, the method comprising:
preparing a structure that comprises a substrate, a first plurality of fin members with a first-type doping concentration value, and a second plurality of fin members with a second-type doping concentration value;
forming a first-type region with a first-type doping concentration value and a second-type region with a second-type doping concentration value in the substrate;
processing the second plurality of fin members to form a plurality of second-type fin members; and
processing the first plurality of fin members to form a plurality of first-type fin members, wherein the first-type region and the first-type fin members are n-type if the second-type region and the second-type fin members are p-type, or the first-type region and the first-type fin members are p-type if the second-type region and the second-type fin members are n-type,
wherein the first-type region directly contacts the second-type region in a cross-sectional view of the semiconductor device,
wherein the first-type region directly contacts each of the first-type fin members in the cross-sectional view of the semiconductor device, and
wherein the second-type region directly contacts each of the second-type fin members in the cross-sectional view of the semiconductor device.

11. The method according to claim 10,
wherein the first-type doping concentration value of the first-type fin members is greater than the first-type doping concentration value of the first-type region, and
wherein the second-type doping concentration value of the second-type fin members is greater than the second-type doping concentration value of the second-type region.

12. The method according to claim 10 or 11,
wherein the substrate comprises a semiconductor portion,
wherein a first-type doping concentration value of the first-type region is higher than a first-type doping concentration value of the semiconductor portion,
wherein the second-type region is positioned between the plurality of second-type fin members and a first portion of the first-type region in a direction perpendicular to the substrate,
wherein the second-type region is positioned between the semiconductor portion and a second portion of the first-type region in a direction parallel to the substrate, and
wherein the second-type region directly contacts each of the semiconductor portion, the first portion of the first-type region, and the second portion of the first-type region.

13. The method according to any one of the claims 10-12,
wherein the second-type region is positioned between the plurality of second-type fin members and a first portion of the first-type region in a direction perpendicular to the substrate,
wherein the second-type region is positioned between a second portion of the first-type region and a third portion of the first-type region in a direction parallel to the substrate, and
wherein the second-type region directly contacts each of the first portion of the first-type region, the second portion of the first-type region, and the third portion of the first-type region.

14. The method according to any one of the claims 10-13 comprising: providing a dielectric member,
wherein each of the first-type region, the second-type region, at least one first-type fin member among the first-type fin members, and at least one second-type fin member among the second-type fin members directly contacts the dielectric member,
wherein the dielectric member, the at least one first-type fin member, and the at least one second-type fin member directly contact a same flat side of the substrate, and
wherein the dielectric member is shorter than each of the at least one first-type fin member and the at least one second-type fin member with reference to the flat side of the substrate.

15. The method according to any one of the claims 10-13,
wherein at least one first-type fin member comprises a first first-type fin portion and a second first-type fin portion,
wherein the first first-type fin portion is positioned between the first-type region and the second first-type fin portion, and
wherein a first-type doping concentration value of the first first-type fin portion is equal to the first-type doping concentration value of the first-type region and is less than a first-type doping concentration value of the second first-type fin portion.

16. The method according to claim 15 comprising: providing a dielectric member,
wherein each of the first-type region, the second-type region, the first first-type fin portion, the second first-type fin portion, and at least one second-type fin member among the second-type fin members directly contacts the dielectric member,
wherein a top side of the dielectric member is positioned farther to a top side of the substrate than a top side of the first first-type fin portion, and
wherein the top side of the dielectric member is positioned closer to the top side of the substrate than a top side of the second first-type fin portion.

17. The method according to claim 16,
wherein the at least one second-type fin member comprises a first second-type fin portion and a second second-type fin portion,
wherein the at least one first second-type fin portion is positioned between the second-type region and the second second-type fin portion,
wherein a second-type doping concentration value of the first second-type fin portion is equal to the second-type doping concentration value of the second-type region and is less than a second-type doping concentration value of the second second-type fin portion, and
wherein each of the first second-type fin portion and the second second-type fin portion directly contacts the dielectric member.
